# EUROPÄISCHE PATENTSCHRIFT

(11) **EP 2 336 981 B1**
(45) Veröffentlichungstag und Bekanntmachung des Hinweises auf die Patenterteilung: **27.03.2013**
(21) Anmeldenummer: 10189376.6
(22) Anmeldetag: 29.10.2010
(51) Int. Cl.: G07C 7/00, H05K 5/02

(54) **Manipulationssicherer Fahrtenschreiber**
Manipulation-proof tacograph device
Tachygraphe protégé contre la manipulation

(30) Priorität: 19.11.2009 DE 102009053775
(43) Veröffentlichungstag der Anmeldung: 22.06.2011
(73) Patentinhaber: Continental Automotive GmbH, 30165 Hannover (DE)
(72) Erfinder: Höni, Helmut, 78733, Aichhalden (DE); Klostermeier, Dieter, 78050, Villingen-Schwenningen (DE); Wahler, Torsten, 78073, Bad Dürrheim (DE); Wolf, Peter, 78078, Niedereschach (DE)

(56) Entgegenhaltungen:
- EP-A1- 1 282 346
- WO-A2-01/63994
- DE-A1-102006 026 222
- DE-A1-102007 017 893

## Beschreibung

Die Erfindung betrifft einen Fahrtenschreiber, der einen unberechtigten Eingriff zuverlässig nachweisbar macht.

In aktuellen Fahrtenschreibern werden fahrer- und fahrzeugrelevante Daten digital gespeichert. Dabei findet die Speicherung entweder auf einer personenbezogenen Fahrerkarte, wie beispielsweise einer Chipkarte und/oder in einem Massenspeicher des Fahrtenschreibers statt.

Da bei einem Kontrollgerät immer die Gefahr einer Manipulation besteht, muss sichergestellt werden, dass schon der Versuch, in das Innere des Gerätes zu gelangen, um dort Veränderungen vorzunehmen, sicher erkannt wird.

Nach dem Stand der Technik sind verschiedene Möglichkeiten bekannt, einen Manipulationsversuch erkennbar zu machen. Im einfachsten Fall kann eine Schraube, mit welcher eine das Gehäuse des Fahrtenschreibers verschließende Frontblende befestigt ist, mittels einer Kunststoffkappe (Plombe) geschützt werden. Diese Sicherung genügt jedoch den erforderlichen Ansprüchen nicht, da eine beschädigte Plombe sehr leicht durch eine neue ersetzt werden kann ohne dass ein Manipulationsversuch erkennbar wird. Neben Plomben können auch Siegel auf Schrauben aufgeklebt werden, die den Fahrtenschreiber verschließen.

Eine weitere Lösung nach dem Stand der Technik sieht einen Schalter auf einer Systemleiterplatte des Fahrtenschreibers vor, der von einer Lasche am Gehäuseboden permanent gedrückt wird. Der Schaltzustand des Schalters wird von einem internen Sicherheitssystem des Fahrtenschreibers ständig überprüft. Entfernt man nun den Gehäuseboden, wird eine Änderung des Schaltzustandes registriert und es erfolgt ein Eintrag im Fehlerspeicher des Fahrtenschreibers. Der Schalter und die Lasche werden dabei so am Gehäuseboden ausgeführt, dass eine Manipulation von außen nicht möglich ist, ohne sichtbare Spuren am Fahrtenschreiber zu hinterlassen. Auf diese Weise wird die Registrierung des Entfernens des Gehäusebodens sichergestellt.

Besondere Anforderungen ergeben sich, wenn die Frontblende austauschbar gestaltet werden soll. Hierbei sollte es möglich sein, dass beispielsweise eine ausgewählte Fachwerkstatt eine beschädigte Frontblende gegen eine neue ersetzen kann, ohne dass dies als Manipulationsversuch gewertet wird.

In einer Lösung nach dem Stand der Technik wird die Systemleiterplatte eines Fahrtenschreibers mit einer Displayplatte, die das entfernbare Display trägt, mittels einer Flachbandleitung kontaktiert. Diese Lösung hat jedoch eine Reihe von Nachteilen. So entstehen durch Material und Montage verhältnismäßig hohe Kosten. Darüber ist eine aufwändige Überwachung der Kontaktierung notwendig, damit sichergestellt ist, dass der Kontakt richtig geschlossen ist.

Die EP 1 282 346 A1 betrifft einen manipulationssicheren Fahrtenschreiber, dessen Gehäuse aus einem Grundkörper und einem Deckel besteht, wobei beim Öffnen des Gehäuses durch das Unterbrechen eines Stromkreises, der mittels Stecker und Buchsen, die in jeweiligen Teilen des Gehäuses vorhanden sind, etabliert ist, eine Manipulation festgestellt werden kann.

Aus der WO 01/63994 A2 ist ein manipulationssicheres Gehäuse für elektronische Geräte zur Speicherung sensitiver Informationen bekannt.

Zudem beschreibt die DE 10 2006 026 222 A1 einen Fahrtschreiber für ein Kraftfahrzeug, der eine elektrische Leitung zur Verbindung zweier elektronischer Baugruppen aufweist, wobei die elektrische Leitung als Schlaufe ausgeführt ist, um kondensierende Feuchtigkeit abzuführen.

Die DE 10 2007 017 893 A1 betrifft eine Detektionsvorrichtung mit einem Datenspeicher, eine Kontrolleinheit mit einem nichtflüchtigen Speicher sowie einer Kontrolleinheit, die in einem Gehäuse angeordnet sind. Die Kontrolleinheit ist zum Erkennen des Öffnens des Gehäuses ausgebildet.

Ausgehend vom Stand der Technik ist es die Aufgabe der vorliegenden Erfindung, die oben genannten Probleme zu lösen und einen Fahrtenschreiber zur Verfügung zu stellen, der ein unberechtigtes Öffnen sicher detektieren kann, gleichzeitig aber unempfindlich ist gegen irrtümlich Detektionen von Manipulationsversuchen. Es sollte vorteilhafterweise außerdem möglich sein, einen Austausch des verschließenden Elementes bei Beschädigungen zu ermöglichen, ohne die Meldung eines Manipulationsversuches auszulösen.

Diese Aufgaben werden gelöst durch den manipulationssicheren Fahrtenschreiber nach Anspruch 1. Die abhängigen Ansprüche geben vorteilhafte Weiterbildungen des erfindungsgemäßen Fahrtenschreibers an.

Der erfindungsgemäße manipulationssichere Fahrtenschreiber weist ein Gehäuse mit einer Zugangsöffnung auf, welche durch ein Verschlusselement verschließbar ist. Das Verschlusselement entspricht normalerweise der Frontblende des Fahrtenschreibers, in speziellen Ausgestaltungen wäre es aber auch möglich, den Zugang zum Inneren des Fahrtenschreibers, also dem Inneren seines Gehäuses, durch andere Zugänge zu ermöglichen.

An dem Gehäuse und dem Verschlusselement sind nun einander zugeordnet zumindest eine Buchse und ein Stecker so angeordnet, dass der Stecker in die Buchse eingreift, wenn das Verschlusselement die Zugangsöffnung des Gehäuses verschließt. Es kann hierbei zumindest eine Buchse am Gehäuse und ein ihr zugeordneter Stecker am Verschlusselement angeordnet sein, und/oder es kann zumindest ein Stecker am Gehäuse und eine ihm zugeordnete Buchse am Verschlusselement angeordnet sein. Buchse und Stecker sind an dem Gehäusekörper bzw. dem Verschlusselement in einer festen Position und im Wesentlichen unbeweglich angeordnet.

Buchse und Stecker sind nun so angeordnet und ausgebildet, dass, sobald das Verschlusselement gegenüber der Zugangsöffnung bewegt wird, sich der Stecker aus der ihm zugeordneten Buchse entfernt, so dass keine Verbindung zwischen Stecker und Buchse mehr besteht.

Der erfindungsgemäße Fahrtenschreiber kann typischerweise ein quaderförmiges Gehäuse aufweisen, dessen Abmessungen den Einschub in eine hierfür in einem Kraftfahrzeug, beispielsweise einem LKW, vorgesehene Öffnung erlauben. Die Zugangsöffnung wird hierbei dadurch gebildet, dass eine Seitenfläche des quaderförmigen Gehäuses offen ist. Über diese Öffnung kann das Verschlusselement in Form einer Frontblende angeordnet werden. Im Gehäuse kann eine Systemleiterplatte angeordnet sein, die beispielsweise parallel zu einer Bodenfläche des quaderförmigen Gehäuses angeordnet ist. Die Frontblende kann beispielsweise eine Displayleiterplatte aufweisen, welche im gehäuseverschließenden Zustand im Wesentlichen parallel zur offenen Seitenfläche des Gehäuses liegt. In einer solchen Ausgestaltung ist es vorteilhaft, wenn die zumindest eine Buchse auf der Systemleiterplatte so angeordnet ist, dass ihre Öffnung sich parallel zur Systemleiterplatte erstreckt und dass der Stecker an der Displayleiterplatte zu deren Fläche senkrecht steht. Alternativ kann auch der Stecker an der Systemleiterplatte so angeordnet sein, dass er sich zu dieser parallel erstreckt. Die Buchse ist dann an der Displayleiterplatte so angeordnet, dass ihre Öffnung senkrecht zur Ebene der Displayleiterplatte steht.

Stecker und Buchse sind vorzugsweise als Board-to-Board-Steckverbindung (B2B-Verbindung) ausgebildet.

Besonders zu bevorzugen ist, dass zumindest ein Stecker und/oder zumindest eine Buchse toleranzausgleichend ist, so dass bei Bewegung des Verschlusselementes eine (ggf. elektrisch leitfähige) Verbindung zwischen Buchse und Stecker so lange erhalten bleibt, bis das Verschlusselement und das Gehäuse so weit getrennt sind, dass das Innere des Gehäuses von außen zugänglich ist und/oder dass sich ein Spalt in das Gehäuseinnere zwischen Verschlusselement und Gehäuse öffnet. Vorzugsweise kann die Kombination von Stecker und Buchse durch entsprechende Konstruktionsmerkmale Toleranzen im Bereich von ≥ ± 0,01 mm, besonders bevorzugt ≥ 0,05 mm, besonders bevorzugt ≥ 0,1 mm, besonders bevorzugt ≥ 0,5 mm und/oder ≤ 1 mm, besonders bevorzugt ≤ 0,8 mm, besonders bevorzugt ≤ 0,6 mm, Bewegung des Steckers gegenüber der Buchse ausgleichen.

Bevorzugt sind Stecker und Buchse, wenn das Verschlusselement das Gehäuse verschließt, so im Inneren des Gehäuses angeordnet, dass beim Öffnen des Gehäuses und/oder beim Bewegen des Verschlusselementes eine Trennung von Stecker und Buchse stattfindet, bevor der Stecker, die Buchse und/oder das Gehäuseinnere von außerhalb des Gehäuses zugänglich sind. Zugänglichkeit in diesem Sinne kann bedeuten, dass ein freier Bereich zwischen Gehäuse und Verschlusselement entsteht, durch den in das Innere des Gehäuses eingegriffen werden kann. Ein solcher Durchgang bzw. Spalt sollte dabei weder gerade noch mit Krümmungen in Richtung von außen in das Innere des Gehäuses möglich sein, da ein Kurzschließen von Kontakten beispielsweise auch mit einem elastischen, leitfähigen Element, möglich wäre.

Bevorzugt ist das Verschlusselement mit einem oder mehreren Rastelementen am Gehäuse befestigbar, um dieses zu verschließen. Dabei sind dann vorzugsweise Buchse und Stecker so angeordnet, dass sie erst dann ineinander greifen und/oder einen Kontakt herstellen, wenn alle Rastelemente eingerastet sind. In diesem Fall sollten Stecker und Buchse voneinander getrennt werden, sobald zumindest ein Rastelement gelöst wird. Auf diese Weise ist schon das Lösen eines einzelnen Rastelementes als Manipulationsversuch erkennbar. Ein entsprechendes Lösen und Ineinandergreifen der Steckverbindung beim Lösen bzw. Einrasten der Rastelemente kann z.B. dadurch bewirkt werden, dass die Rastelemente am Verschlusselement und/oder Gehäuse fest angeordnet sind. Da auch der Stecker bzw. die Buchse am Verschlusselement bzw. Gehäuse fest angeordnet ist, muss das Verschlusselement zum Lösen des Rastelementes bewegt werden und bewegt dabei den Stecker aus der Buchse.

Bevorzugterweise sind Buchse und Stecker so angeordnet, dass sie nur so lange ineinander sitzen, wie kein in das Gehäuseinnere durchgängiger Spalt zwischen Gehäuse und Verschlusselement existiert, und voneinander getrennt werden, sobald sich ein Spalt in das Gehäuseinnere zwischen dem Gehäuse und dem Verschlusselement öffnet. Auf diese Weise wird sichergestellt, dass Buchse und Stecker voneinander gelöst sind, bevor eine Manipulation im Inneren des Fahrtenschreibers von außen möglich wird.

Das Trennen von Buchse und Stecker sollte vorzugsweise im Fahrtenschreiber registrierbar sein. Hierbei ist es bevorzugt, wenn Buchse und/oder Stecker zumindest einen elektrischen Kontakt aufweisen, der elektrisch leitend geschlossen ist, wenn Buchse und Stecker ineinander sitzen und der elektrisch isolierend geöffnet ist, wenn Buchse und Stecker getrennt sind.

Der elektrische Kontakt kann hierbei in nur einem Element aus Buchse und Stecker angeordnet sein. Das andere Element aus Stecker und Buchse kann hierbei dann zumindest bereichsweise elektrisch leitend sein, so dass es den Kontakt im jeweils anderen Bauteil schließt. Es ist aber auch möglich, dass der Stecker einen Kontakt aufweist und die Buchse einen Kontakt aufweist, die einander kontaktieren, so lange Stecker und Buchse ineinander greifen und die voneinander getrennt werden, wenn Buchse und Stecker getrennt werden.

Sofern Buchse und/oder Stecker in dieser Weise einen elektrischen Kontakt aufweisen, mit dem das Trennen des Steckers und damit ein Manipulationsversuch detektierbar ist, soll im Sinne dieser Schrift das Trennen oder Lösen von Buchse und Stecker bedeuten, dass der elektrische Kontakt unterbrochen wird und ein Ineinandergreifen, Ineinandersitzen, Einrasten oder Schließen von Stecker und Buchse bedeuten, dass der elektrische Kontakt geschlossen wird bzw. ist. Der elektrische Kontakt wird also immer dann geöffnet bzw. getrennt, wenn ein Ereignis eintritt, das als Manipulationsversuch zu werten ist.

Die elektrische Verbindung kommt bevorzugt erst dann zustande, wenn die Frontblende mit integrierter Displaybaugruppe auf das Gehäuse aufschnappt. D.h., der Hub, bei dem die elektrische Kontaktierung stattfindet, ist relativ klein. Hierdurch ist bei einer Demontage der Frontblende der Verfahrweg bis zum Unterbrechen der elektrischen Verbindung ähnlich klein.

Besonders bevorzugt weisen der Stecker und die Buchse ein oder mehrere Kontakte auf, wobei jeweils ein Kontakt des Steckers einem Kontakt der Buchse so zugeordnet ist, dass dieser Kontakt des Steckers den entsprechenden Kontakt der Buchse kontaktiert, wenn der Stecker in der Buchse sitzt. Besonders bevorzugt ist es dabei, wenn der Stecker und die Buchse neben der Überwachungsfunktion auch die Datenleitung von einer Displayverschaltung am Verschlusselement zur im Gehäusekörper angeordneten Elektronik ermöglicht. Stecker und Buchse haben hier also die Doppelfunktion, eine Überwachung des Fahrtenschreibers bezüglich Manipulationsversuchen zu ermöglichen und gleichzeitig die elektrische Kontaktierung und Datenleitung von Displaybaugruppe zur Steuerelektronik im Gehäuse zu gewährleisten.

Bevorzugterweise weist der Fahrtenschreiber zumindest eine Kontrolleinheit auf, die kontrolliert, ob Buchse und Stecker ineinandergreifen oder getrennt sind. Die Kontrolle kann hierbei kontinuierlich oder diskontinuierlich in bestimmten Zeitabständen oder zu bestimmten Zeiten erfolgen. Bevorzugterweise erfolgt die Kontrolle elektronisch, wobei der oben beschriebene Kontakt in Stecker und/oder Buchse von Vorteil ist.

Durch die Überprüfung der Verbindung kann eine Entnahme, Anzahl und Dauer einer Demontage des Verschlusselementes überprüft und registriert werden.

Bevorzugt weist der Fahrtenschreiber außerdem eine Speichervorrichtung auf, in welche die Kontrolleinheit ein Trennen von Stecker und Buchse einschreiben und speichern kann.

Erfindungsgemäß weist der Fahrtenschreiber außerdem eine Leseeinheit auf, mit welcher ein entfernbarer Speicher lesbar ist. Ein solcher entfernbarer Speicher kann beispielsweise eine Chip-Karte sein. Der Fahrtenschreiber ist so ausgeführt, dass bei Auslesen einer vorbestimmten Information aus dem entfernbaren Speicher durch die Leseeinheit verhinderbar ist, dass beim Trennen von Stecker und Buchse ein Fehlereintrag in die Speichervorrichtung geschrieben wird. Der entfernbare Speicher kann hierbei beispielsweise eine Werkstattkarte sein, die an vertrauenswürdige Werkstätten ausgegeben wird und,es diesen erlaubt, das Verschlusselement des Fahrtenschreibers zu öffnen und gegebenenfalls auszutauschen, ohne die Meldung eines Manipulationsversuches zu verursachen. Vorteilhafterweise sind Speichervorrichtung, entfernbarer Speicher, Kontrolleinheit und/oder Leseeinheit als digitalelektronische integrierte Schaltkreise ausgeführt.

Der Stecker und die Buchse können auf verschiedene Weise ausgeführt sein, um im erfindungsgemäßen Fahrtenschreiber zur Anwendung zu kommen. Der Stecker kann beispielsweise quaderförmig sein, vorzugsweise mit einer Mehrzahl von nebeneinander angeordneten Kontakten, wobei besonders bevorzugt der Stecker länglich gestaltet ist und die Kontakte in Längsrichtung nebeneinander angeordnet sind. Besonders bevorzugt liegt die Längsrichtung eines solchen Steckers parallel zu einer Displayleiterplatte und einer Systemleiterplatte, wenn der Fahrtenschreiber sich im geschlossenen Zustand befindet. Die Buchse ist dem Stecker entsprechend ausgebildet, d.h. sie weist eine Ausnehmung auf, deren Form mit der Form des Steckers so übereinstimmt, dass der Stecker im Wesentlichen formschlüssig in die Buchse einführbar ist.

Sofern eine Displayleiterplatte vorgesehen ist, ist diese vorzugsweise fester Bestandteil der Frontblende bzw. des Verschlusselementes. Es ist bevorzugt, wenn das Verschlusselement am Gehäuse, bevorzugterweise zusätzlich, mittels zumindest einer Schraube sicherbar ist. Besonders bevorzugt ist diese zumindest eine Schraube von außen nicht zugänglich.

Die Erfindung ermöglicht es, auf eine Flachbandleitung zwischen einer eventuell vorhandenen Systemleiterplatte und einer Displayleiterplatte zu verzichten. Stattdessen werden Stecker und Buchse verwendet, die gleichzeitig die Überwachungsfunktion übernehmen. Es werden also keine weiteren Schalter oder Betätigungselemente benötigt. Es ist möglich, zu überwachen, ob die Frontblende entfernt wurde.

Im Folgenden soll die Erfindung anhand einiger Figuren beispielhaft erläutert werden. Dabei entsprechen gleiche Bezugszeichen gleichen oder entsprechenden Merkmalen. Die in den Figuren gezeigten Merkmale können auch einzeln oder in beliebigen anderen als den gezeigten Kombinationen erfindungsgemäß verwirklicht sein.

Es zeigt
- Figur 1: einen erfindungsgemäßen Fahrtenschreiber im geöff- neten Zustand;
- Figur 2: einen erfindungsgemäßen Fahrtenschreiber im ge- schlossenen Zustand;
- Figur 3: einen erfindungsgemäßen Fahrtenschreiber im Zustand eines Manipulationsversuches;
- Figur 4: eine Displayleiterplatte für den erfindungsgemäßen Fahrtenschreiber; und
- Figur 5: eine Systemleiterplatte für den erfindungsgemäßen Fahrtenschreiber.

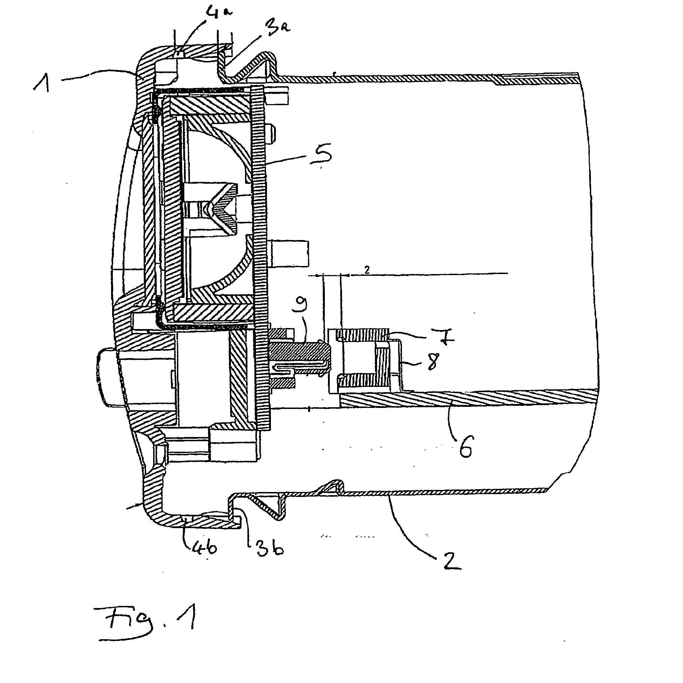

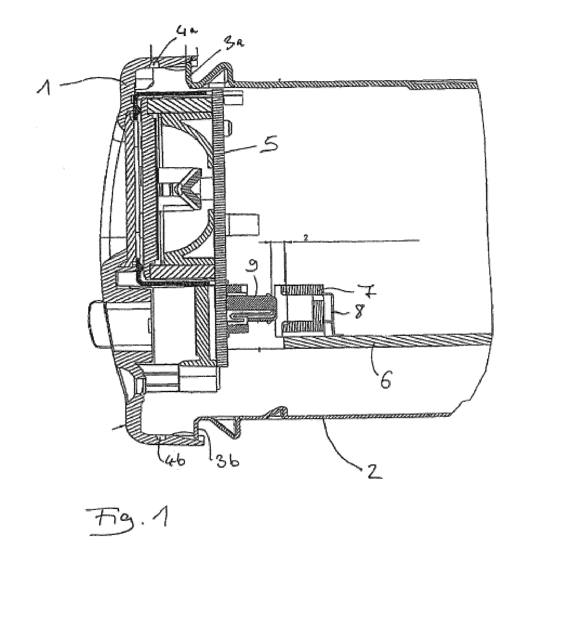

Figur 1 zeigt einen erfindungsgemäßen Fahrtenschreiber im geöffneten Zustand, bei welchem eine Frontblende 1 über eine Öffnung in einem Gehäuse 2 geschoben wurde, jedoch noch nicht zum Verschluss eingerastet ist. Das Gehäuse 2 weist an seiner offenen Seite federgelagerte Einrasthaken 3a, 3b auf, die in entsprechende Nuten 4a, 4b einrasten können. Die Frontblendenbaugruppe 1 weist außerdem eine Displayleiterplatte 5 auf, auf welcher elektronische Elemente des Displays angeordnet sind. Die Displayleiterplatte 5 ist mit der Frontblende 1 eingeschnappt und/oder von innen her verschraubt. Dabei ist die Schraube und/oder die Schnappverbindung bevorzugt von außen nicht zugänglich, so dass sie nicht gelöst werden können, wenn das Gehäuse verschlossen ist. Das Gehäuse 2 des Fahrtenschreibers weist eine Systemleiterplatte 6 auf, auf welcher beispielsweise eine Verarbeitungselektronik des Fahrtenschreibers angeordnet sein kann. Im verschlossenen Zustand und im in Figur 1 gezeigten aufgestülpten Zustand steht die Displayleiterplatte 5 im Wesentlichen parallel zur offenen Wand des Gehäusekörpers 2. Die Systemleiterplatte 6 steht im Wesentlichen parallel zu einer Unterseite des Gehäusekörpers 2 und im Wesentlichen senkrecht zur Displayleiterplatte 5. Im gezeigten Beispiel ist nun auf der Systemleiterplatte 6 eine toleranzausgleichende Buchse 7 angeordnet, die durch Kontakte 8 elektrisch kontaktiert ist. Der Buchse 7 gegenüber ist auf der Displayleiterplatte 5 eine Steckerleiste 9 angeordnet, die, wenn die Frontblendenbaugruppe in die Einrastposition bewegt wird, in die Buchse 7 eingreift. In Figur 1 hat die Kontaktierung noch nicht stattgefunden, da der Stecker 9 sich noch vor der Buchse 7 befindet.

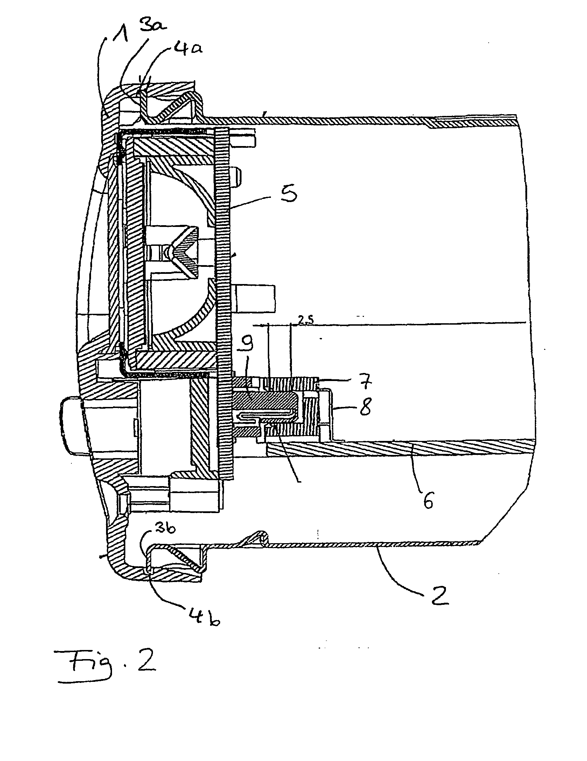

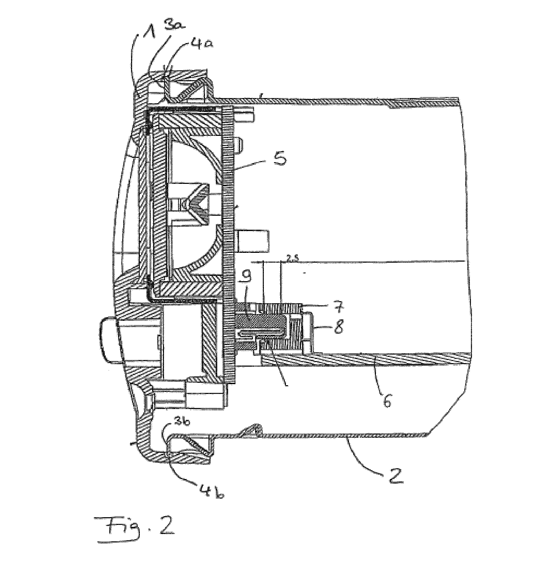

Figur 2 zeigt nun den in Figur 1 gezeigten Fahrtenschreiber in einem Zustand, in dem die Frontblendenbaugruppe 1 mit dem Gehäuse 2 eingerastet ist und dieses verschließt. Hierbei sind die Feder-gelagerten Rasthaken 3a, 3b in die Ihnen zugeordneten Nuten 4a, 4b eingerastet. Gleichzeitig wurde hier der Stecker 9 in die Buchse 7 eingeführt, was über den Kontakt 8 überprüft werden kann. Das Ergebnis der Überprüfung kann dann in einer auf der Systemleiterplatte 6 angeordneten Speichervorrichtung gespeichert werden. Der Fahrtenschreiber kann eine Leseeinheit aufweisen, mit welcher externe entfernbare Speicherkarten lesbar sind und das Einschreiben einer Fehlerinformation in die Speichervorrichtung unterdrückt werden kann.

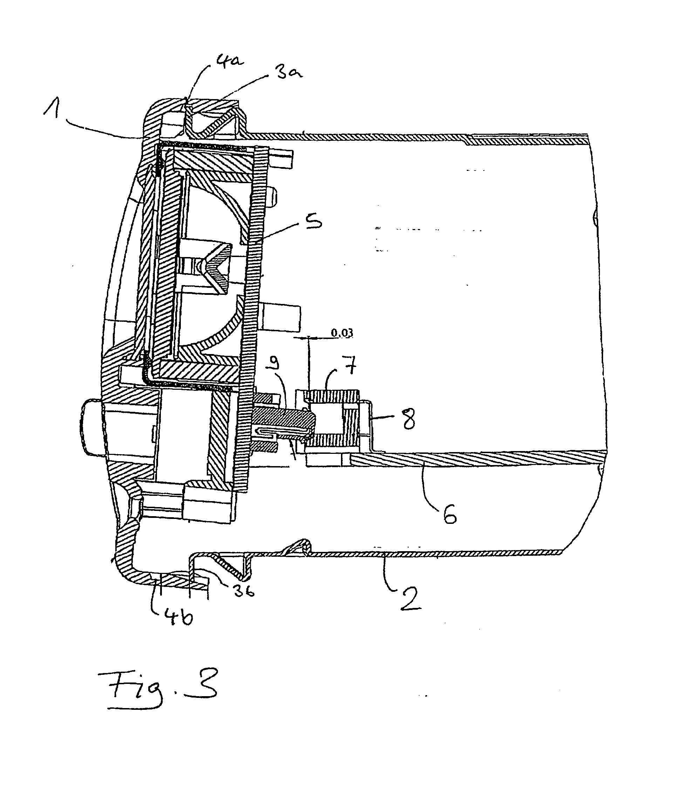

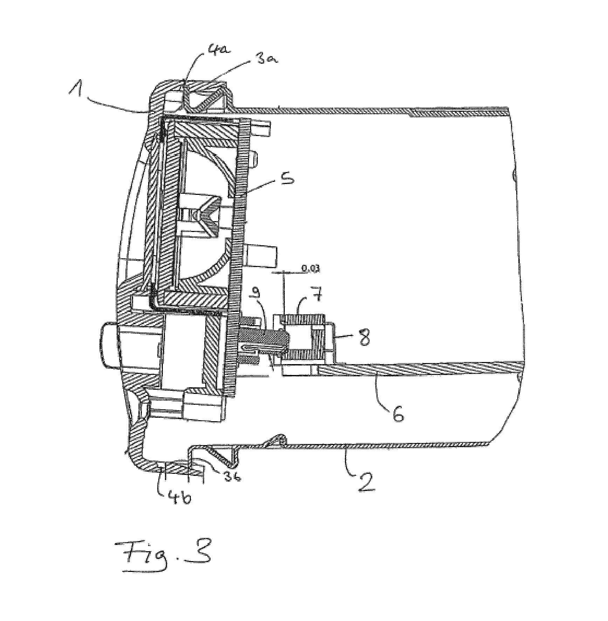

Figur 3 zeigt den erfindungsgemäßen Fahrtenschreiber in einem Zustand, wie er vorliegt, wenn ein Manipulationsversuch unternommen wird. Hierbei wurde der Rasthaken 3b aus der ihm zugeordneten Buchse 4b entfernt, während Rasthaken 3a in seiner zugeordneten Buchse 4a eingerastet verblieben ist. In dieser Situation ist die Frontblende 1 gegenüber der Ebene der Seitenwand des Gehäuses 2 gekippt. Hierdurch wurde die Position des Steckers 9 gegenüber der Buchse 7 verändert. Im gezeigten Beispiel greift nun der Stecker 9 nicht mehr in die Buchse 7 ein und der elektrische Kontakt, der über die Kontaktierung 8 auswertbar ist, wurde getrennt. In dieser Situation würde eine Fehlermeldung in die hierfür vorgesehene Speichervorrichtung eingeschrieben werden.

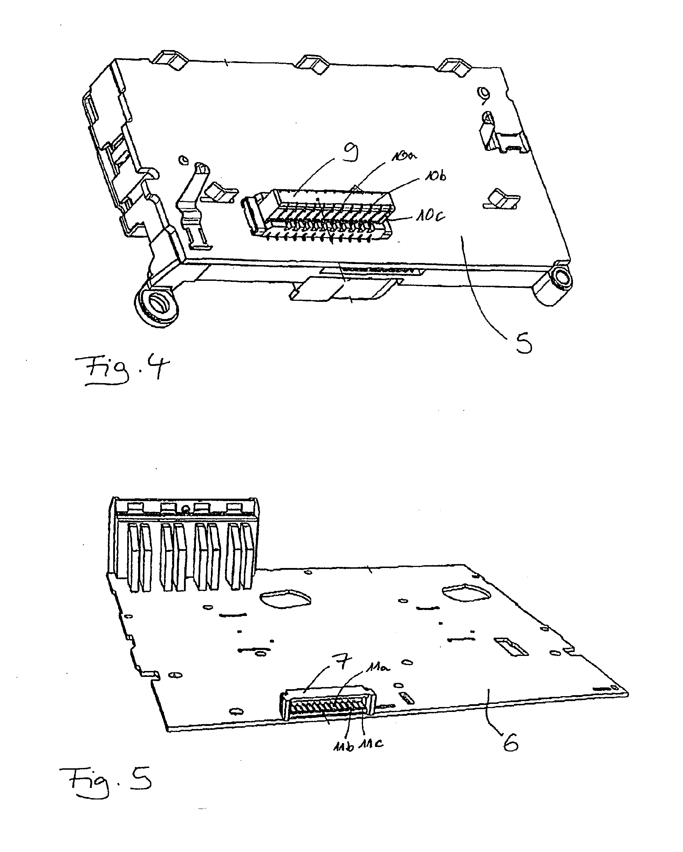

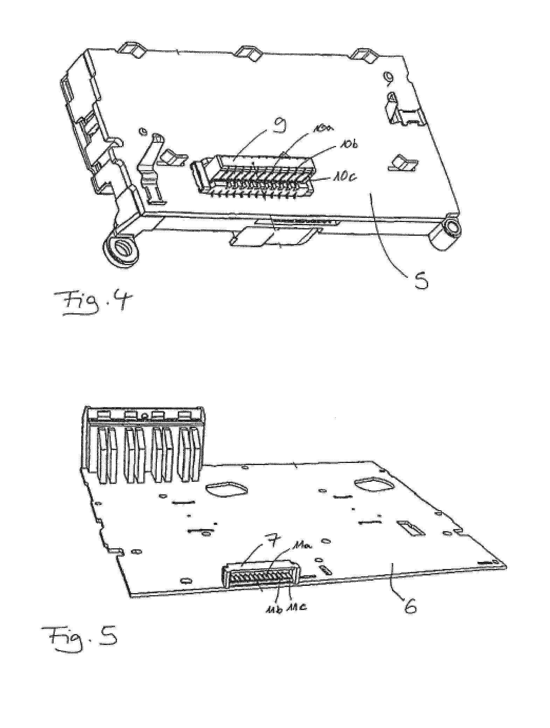

Figur 4 zeigt eine Displayleiterplatte 5 mit einem darauf angeordneten Stecker 9, der hier als längliche Steckerleiste mit einer Vielzahl von nebeneinander angeordneten Kontakten 10a, 10b, 10c ausgeführt ist.
Figur 5 zeigt eine Systemleiterplatte 6, die eine dem in Figur 4 gezeigten Stecker 9 entsprechende Buchse 7 aufweist. Die Steckerleiste 9 ist mit ihrer Längsrichtung parallel zur Unterkante der Displayleiterplatte 5 angeordnet. Die Buchse 7 ist am Rand der Systemleiterplatte 6 so angeordnet, dass ihre Längsrichtung parallel zu diesem Rand ist. Der Stecker 9 und die Buchse 7 sind nun so angeordnet und ausgerichtet, dass, wenn die Frontblende 1 mit der Displayleiterplatte 5 den Gehäusekörper 2 mit der darin befindlichen Systemleiterplatte 6 verschließt, der Stecker 9 in der Buchse 7 sitzt. Die Buchse 7 weist eine Vielzahl von Kontakten 11a, 11b, 11c auf, die, wenn der Stecker 9 in die Buchse 7 eingreift, die Kontakte 10a, 10b, 10c des Steckers 9 elektrisch kontaktieren.

## Patentansprüche

1. Manipulationssicherer Fahrtenschreiber mit einem Gehäuse (2), das eine Zugangsöffnung aufweist, und einem Verschlusselement (1), mit welchem die Zugangsöffnung verschließbar ist, wobei das Gehäuse (2) zumindest eine am Gehäuse (2) angeordnete Buchse (7) aufweist und das Verschlusselement (1) zumindest einen am Verschlusselement (1) angeordneten, der zumindest einen Buchse (7) zugeordneten Stecker (9) aufweist und/oder das Gehäuse (2) zumindest einen am Gehäuse (2) angeordneten Stecker (9) aufweist und das Verschlusselement (1) zumindest eine am Verschlusselement (1) angeordnete, dem zumindest einen Stecker (9) zugeordnete Buchse (7) aufweist, wobei der Stecker (9) und die Buchse (7) in fester Position unbeweglich so angeordnet sind, dass der jeweilige Stecker (9) in der ihm zugeordneten Buchse (7) sitzt, wenn das Gahäuse (2) durch das Verschlusselement (1) verschlossen ist und sich aus der ihm zugeordneten Buchse (7) entfernt, sobald das Verschlusselement (1) gegenüber der Zugangsöffnung bewegt und/oder von dieser entfernt wird, **dadurch gekennzeichnet, dass** der Fahrtenschreiber eine Kontrolleinheit aufweist, die kontrolliert, ob die Buchse (7) und der Stecker (9) ineinander sitzen, sowie eine Speichervorrichtung, wobei durch die Kontrolleinheit ein Trennen des Steckers von der Buchse in die Speichervorrichtung schreibbar ist und dass der Fahrtenschreiber eine Leseeinheit zum Lesen eines entfernbaren Speichers aufweist, wobei das Einschreiben des Trennens in die Speichervorrichtung durch Auslesen einer vorbestimmten Information durch die Leseeinheit aus dem entfernbaren Speicher verhinderbar ist.

2. Fahrtenschreiber nach dem vorhergehenden Anspruch, **dadurch gekennzeichnet, dass** der zumindest eine Stecker (9) und die zumindest eine Buchse (7), wenn das Verschlusselement (1) das Gehäuse (2) verschließt, so im Inneren des Gehäuses angeordnet sind, dass beim Öffnen des Gehäuses und/oder Bewegen des Verschlusselementes eine Trennung des Steckers von der Buchse stattfindet, bevor der Stecker, die Buchse und/oder das Gehäuseinnere von außerhalb des Gehäuses zugänglich sind.

3. Fahrtenschreiber nach einem der vorhergehenden Ansprüche, **dadurch gekennzeichnet, dass** das zumindest eine Verschlusselement (1) mit einem oder mehreren Rastelementen (3a, 3b) am Gehäuse (2) zum Verschließen des Gehäuses befestigbar ist, und dass die Buchse (7) und der Stecker (9) so angeordnet sind, dass sie erst ineinander greifen, wenn alle Rastelemente eingerastet sind, und voneinander getrennt werden, sobald ein Rastelement gelöst wird.

4. Fahrtenschreiber nach einem der vorhergehenden Ansprüche, **dadurch gekennzeichnet, dass** die Buchse (7) und der Stecker (9) so angeordnet sind, dass die Buchse und der Stecker nur so lange ineinander sitzen, wie kein in das Gehäuseinnere durchgängiger Spalt zwischen dem Gehäuse (2) und dem Verschlusselement (1) existiert, und voneinander getrennt werden, sobald sich ein Spalt in das Gehäuseinnere zwischen dem Gehäuse und dem Verschlusselement öffnet.

5. Fahrtenschreiber nach einem der vorhergehenden Ansprüche, **dadurch gekennzeichnet, dass** die Buchse (7) und/oder der Stecker (9) zumindest einen elektrischen Kontakt (8) aufweisen, der geschlossen ist, wenn die Buchse und der Stecker ineinander sitzen und der geöffnet ist, wenn die Buchse und der Stecker getrennt sind.

6. Fahrtenschreiber nach einem der vorhergehenden Ansprüche, **dadurch gekennzeichnet, dass** das Verschlusselement (1) eine Displayleiterplatte (5) und das Gehäuse (2) eine Systemleiterplatte (6) des Fahrtenschreibers aufweist, auf denen die Stecker (9) und Buchsen (7) angeordnet sind.

7. Fahrtenschreiber nach einem der vorhergehenden Ansprüche, **dadurch gekennzeichnet, dass** zumindest eine der Buchsen (7) und/oder zumindest einer der Stecker (9) toleranzanzaugleichend ausgebildet ist und so angeordnet ist, dass bei Bewegung des Verschlusselementes (1) die Buchse und der Stecker höchstens so lange ineinander sitzen, bis das Verschlusselement und das Gehäuse (2) soweit getrennt sind, dass das Innere des Gehäuses von außen zugänglich ist und/oder sich ein Spalt in das Gehäuseinnere zwischen dem Verschlusselement und dem Gehäuse öffnet.

## Claims

1. Tamper-proof tachograph having a housing (2) that comprises an access opening and a closure element (1) with which the access opening can be closed, wherein the housing (2) comprises at least one socket (7) disposed on the housing (2) and the closure element (1) comprises at least one plug (9) associated with a socket (7) disposed on the closure element (1) and/or the housing (2) comprises at least one plug (9) disposed on the housing (2) and the closure element (1) comprises at least one socket (7) disposed on the closure element (1) and associated with the at least one plug (9), wherein the plug (9) and the socket (7) are immovably disposed in a fixed position so that the respective plug (9) sits in its associated socket (7) if the housing (2) is closed by the closure element (1) and is removed from its associated socket (7) as soon as the closure element (1) is moved relative to the access opening and/or is removed therefrom, **characterized in that** the tachograph comprises a monitoring unit that monitors whether the socket (7) and the plug (9) are seated one within the other and a memory device, wherein separation of the plug from the socket can be written into the memory device by the monitoring unit and **in that** the tachograph comprises a reading unit for reading a removable memory, wherein writing the separation into the memory device can be prevented by reading out a predetermined item of information from the removable memory by the reading unit.

2. Tachograph according to the preceding claim, **characterized in that** if the closure element (1) is closing the housing (2) the at least one plug (9) and the at least one socket (7) are disposed in the interior of the housing so that when the housing is opened and/or the closure element is moved, separation of the plug from the socket occurs before the plug, the socket and/or the interior of the housing are accessible from the outside of the housing.

3. Tachograph according to any one of the preceding claims, **characterized in that** the at least one closure element (1) can be attached by means of one or a plurality of latching elements (3a, 3b) to the housing (2) for closure of the housing,
and **in that** the socket (7) and the plug (9) are disposed so that they only engage with each other if all latching elements are latched, and are separated from each other as soon as one latching element is released.

4. Tachograph according to any one of the preceding claims, **characterized in that** the socket (7) and the plug (9) are disposed so that the socket and the plug only sit one within the other whilst there is no passable gap in the interior of the housing between the housing (2) and the closure element (1), and are separated from each other as soon as a gap opens between the housing and the closure element in the interior of the housing.

5. Tachograph according to any one of the preceding claims, **characterized in that** the socket (7) and/or the plug (9) comprise at least one electrical contact (8), which is closed if the socket and the plug are seated one within the other and which is opened if the socket and the plug are separated.

6. Tachograph according to any one of the preceding claims, **characterized in that** the closure element (1) comprises a display circuit board (5) and the housing (2) comprises a system circuit board (6) of the tachograph on which the plug (9) and the socket (7) are disposed.

7. Tachograph according to any one of the preceding claims, **characterized in that** at least one of the sockets (7) and/or at least one of the plugs (9) is designed to be tolerance-compensating and is disposed so that in the event of movement of the closure element (1) the sockets and the plugs sit one inside the other for no longer than the closure element and the housing (2) are separated to such an extent that the interior of the housing is accessible from the outside and/or a gap in the interior of the housing between the closure element and the housing is open.

## Revendications

1. Tachygraphe protégé de la manipulation, comprenant un boîtier (2) qui a une ouverture d'accès et un élément (1) de fermeture, par lequel l'ouverture d'accès peut être fermée, le boîtier (2) ayant au moins une douille (7) montée sur le boîtier (2) et l'élément (1) de fermeture au moins une fiche (9) montée sur l'élément (1) de fermeture et associée à la au moins une douille (7) et/ou le boîtier (2) a au moins une fiche (9) montée sur le boîtier (2) et l'élément (1) de fermeture au moins une douille (7) montée sur l'élément (1) de fermeture et associée à la au moins une fiche (9), la fiche (9) et la douille (5) étant montées immobiles en position fixe, de manière à ce que la fiche (9) respective se trouve dans la douille (7) qui lui est associée, lorsque le boîtier (2) est fermé par l'élément (1) de fermeture, et s'éloigne de la douille (7) qui lui est associée, dès que l'élément (1) de fermeture est déplacé par rapport à l'ouverture d'accès et/ou s'en éloigne, **caractérisé en ce que** le tachygraphe a une unité de contrôle, qui contrôle si la douille (7) et la fiche (9) sont l'une dans l'autre, ainsi qu'un dispositif de mémoire, une séparation de la fiche de la douille pouvant être écrite par l'unité de contrôle dans le dispositif de mémoire, et **en ce que** le tachygraphe a une unité de lecture pour la lecture d'une mémoire pouvant être retirée, l'écriture de la séparation dans le dispositif de mémoire pouvant être empêchée par lecture d'une information déterminée à l'avance par l'unité de lecture dans la mémoire pouvant être retirée.

2. Tachygraphe suivant la revendication précédente, **caractérisé en ce que** la au moins une fiche (9) et la au moins une douille (7), lorsque l'élément (1) de fermeture ferme le boîtier (2), sont disposées à l'intérieur du boîtier, de manière à ce que, lors de l'ouverture du boîtier et/ou du déplacement de l'élément de fermeture, une séparation de la fiche de la douille a lieu avant que la fiche, la douille et/ou l'intérieur du boîtier soient accessibles de l'extérieur du boîtier.

3. Tachygraphe suivant l'une des revendications précédentes, **caractérisé en ce que** le au moins un élément (1) de fermeture peut, pour la fermeture du boîtier, être fixé par un ou par plusieurs éléments (3a, 3b) d'encliquetage au boîtier (2) et **en ce que** la douille (7) et la fiche (9) sont disposées, de manière à ne s'enficher que si tous les éléments d'encliquetage sont encliquetés et à être séparées l'une de l'autre, dès qu'un élément d'encliquetage est désencliqueté.

4. Tachygraphe suivant l'une des revendications précédentes, **caractérisé en ce que** la douille (7) et la fiche (9) sont disposées, de manière à ce que la douille et la fiche ne s'enfichent que jusqu'à ce qu'il n'existe pas de fente traversante à l'intérieur du boîtier entre le boîtier (2) et l'élément (1) de fermeture et soient séparées l'une des l'autre, dès qu'une fente s'ouvre à l'intérieur du boîtier entre le boîtier et l'élément de fermeture.

5. Tachygraphe suivant l'une des revendications précédentes, **caractérisé en ce que** la douille (7) et/ou la fiche (9) ont au moins un contact (8) électrique, qui est fermé, lorsque la douille et la fiche sont enfichées, et qui est ouvert, lorsque la douille et la fiche sont séparées.

6. Tachygraphe suivant l'une des revendications précédentes, **caractérisé en ce que** l'élément (1) de fermeture a une plaquette (5) à circuit imprimé d'affichage et le boîtier (2) a une plaquette (6) à circuit imprimé de système du tachygraphe, sur lesquelles sont montées la fiche (9) et la douille (7).

7. Tachygraphe suivant l'une des revendications précédentes, **caractérisé en ce qu'**au moins l'une des douilles (7) et/ou au moins l'une des fiches (9) est constituée de manière à compenser des tolérances et est disposée de manière à ce que, lors du déplacement de l'élément (1) de fermeture, la douille et la fiche s'enfichent au plus jusqu'à ce que l'élément de fermeture et le boîtier (2) soient si séparés que l'intérieur du boîtier est accessible de l'extérieur et/ou qu'une fente s'ouvre dans l'intérieur du boîtier entre l'élément de fermeture et le boîtier.
